# EUROPEAN PATENT SPECIFICATION

(11) **EP 3 393 224 B1**
(45) Date of publication and mention of the grant of the patent: **19.05.2021**
(21) Application number: 15910721.8
(22) Date of filing: 16.12.2015
(51) Int. Cl.: H05K 13/02, H05K 13/04

(54) **TAPE FEEDER**
BANDZUFÜHRER
DISTRIBUTEUR À BANDE

(43) Date of publication of application: 24.10.2018
(73) Proprietor: Fuji Corporation, Chiryu-shi, Aichi 472-8686 (JP)
(72) Inventor: YAMAZAKI, Yusuke, Chiryu Aichi (JP); OHASHI, Hiroyasu, Chiryu Aichi (JP); MURASE, Hiroki, Chiryu Aichi (JP)
(74) Representative: Grünecker Patent- und Rechtsanwälte PartG mbB
(86) International application number: PCT/JP2015/085263
(87) International publication number: WO 2017/104031

(56) References cited:
- EP-A1- 1 530 415
- JP-A- 2008 277 350
- JP-A- 2010 507 908
- JP-A- 2011 086 857
- US-A1- 2010 180 435
- US-A1- 2012 305 585
- US-A1- 2014 060 749
- US-A1- 2015 053 353

## Description

### Technical Field

The present invention relates to a tape feeder.

### Background Art

A tape feeder feeds and moves a carrier tape carrying electronic components in a conveying direction to supply the electronic components for removal. To cope with various production modes, the tape feeder is required to enable a use of a carrier tape which is shorter than, for example, a carrier tape conveying path (hereinafter, referred to as a "cut tape"). Patent Document 1 discloses a tape feeder having a second conveying path for a cut tape.
Patent Document 2 discloses a component supplying apparatus including a main tape entering port, a component supply port through which components are picked up from a carrier tape, a main tape path extending in a body part from the main tape entering port to the underside of the component supply port, a top tape removing part removing the top tape from the carrier tape on the main tape path upstream of the component supply port, a sub tape entering port, a sub tape path meeting a slope path portion of the main tape path at a meeting point upstream of the top tape removing part, and at least one sprocket wheel engaging with the carrier tape on the main tape path downstream of the meeting point. A length of the sub tape path is shorter than a length of the main tape path from the main tape entering port to the meeting point.

### Prior Art Document

### Patent Document

Patent Document 1: Japanese Patent No. 5521129
Patent Document 2: US 2015/053353 A1

### Summary of the Invention

### Problem to Be Solved by the Invention

In the tape feeder of Patent Document 1, the second conveying path merges into a main conveying pass at an inclined portion thereof which is inclined. This requires the cut tape which travels by way of a merging point on the inclined portion is required to have a certain length.

The invention has been made in view of these situations and an object thereof is to provide a tape feeder which facilitates a loading of a carrier tape and enables a use of a shorter carrier tape.

### Means for Solving the Problem

A tape feeder according to claim 1 feeds and moves a carrier tape carrying electronic components in a conveying direction to supply the electronic components for removal. The carrier tape has a base tape on which storage sections for accommodating an electronic component are formed at regular intervals in the conveying direction and a cover tape for closing the storage sections. The tape feeder includes a feeder main body having formed therein a first inserting portion into which a first carrier tape is inserted and a first conveying path conf igured to support the first carrier tape inserted from the first inserting portion, a sprocket configured to be brought into engagement with either the first carrier tape or a second carrier tape to feed and move the first or second carrier tape, a tape guide configured to guide the engagement of the first or the second carrier tape with the sprocket above the sprocket and having formed thereon a tape separating portion configured to separate the cover tape from the base tape and a removing portion which is opened at an upper surface to enable a removal of the electronic components, a second inserting portion which is disposed in a position located nearer to the removing portion than the first inserting portion and into which the second carrier tape is inserted, and a second conveying path which is a conveying path configured to support the second carrier tape inserted from the second inserting portion and which merges into the first conveying path within a range defined in the conveying direction on the first conveying path where the tape guide is located, wherein the second inserting portion is formed in the tape guide, and wherein the tape guide restricts the second carrier tape inserted from the second inserting portion from moving in the width direction to guide a feeding and moving of the second carrier tape along the second conveying path.

### Advantageous Effects of the Invention

According to the configuration of the invention according to claim 1, the position where the second conveying path merges into the first conveying path is within the range defined in the conveying direction where the tape guide is located. This can shorten a distance from the merging position to the sprocket. In addition, the second inserting portion can be formed close to the range in which the carrier tape can be brought into contact with the sprocket for engagement therewith, and a length of the second conveying path can be shortened. This facilitates a loading of the carrier tape inserted from the second inserting portion and reduces a minimum tape length loadable in the tape feeder, thereby enabling a use of a shorter carrier tape.

### Brief Description of Drawings

[Fig. 1] Fig. 1 is a side view showing an overall feeder of an embodiment.
[Fig. 2] Fig. 2 is a top view of a portion of a carrier tape.
[Fig. 3] Fig. 3 is a perspective view showing a tape guide.
[Fig. 4] Fig. 4 is an enlarged view showing a first conveying path and a second conveying path in the feeder in Fig. 1.
[Fig. 5] Fig. 5 is an enlarged view showing a state in which the carrier tape is loaded.
[Fig. 6] Fig. 6 is an enlarged view showing a state in which a cut tape is inserted. [Fig. 7] Fig. 7 is an enlarged view showing a state in which the cut tape is loaded.
[Fig. 8] Fig. 8 is a cross-sectional view taken along a line VIII-VIII in FIG. 7.
[Fig. 9] Fig. 9 is a perspective view showing a tape guide according to a modified embodiment.

### Mode for Carrying out the Invention

Hereinafter, embodiments embodying a tape feeder of the invention will be described by reference to the drawings. A tape feeder is used in an electronic component mounting machine for mounting electronic components on a circuit board. In the electronic component mounting machine, the tape feeder feeds and moves a carrier tape carrying electronic components in a conveying direction to supply the electronic components for removal. As described above, the tape feeder is a feeder of a tape type. Hereinafter, the tape feeder will also be referred to simply as a "feeder."

### <Embodiments>

### (Outline of Feeder 1)

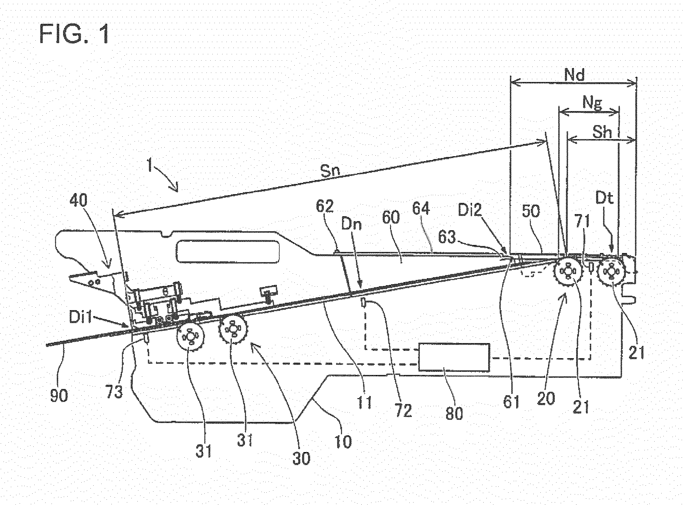

In this embodiment, as shown in Fig. 1, a feeder 1 feeds and moves a carrier tape 90 inserted from a first inserting portion Di1 along a first conveying path R1 to supply electronic components for removal at a removing portion Dt. Further, the feeder 1 feeds and moves a carrier tape 90 inserted from a second inserting portion Di2 along a second conveying path R2 by way of a merging position Pj where the first conveying path R1 and the second conveying path R2 merge together to supply the electronic components for removal at the removing portion Dt.

The feeder 1 is an autoloading type feeder capable of automatically loading the carrier tape 90 when a front end of the carrier tape 90 is inserted in the first insertion portion Dil. When referred to herein, the "loading" means realizing a state in which the carrier tape 90 gets ready to supply the electronic components for removal at the removing portion Dt. For example, when the remaining amount of the current carrier tape 90 in use becomes less than a specified amount, the feeder 1 discharges the current carrier tape 90 and thereafter feeds and moves another carrier tape 90 which is not spliced for replenishment for loading.

### (Configuration of Carrier Tape 90)

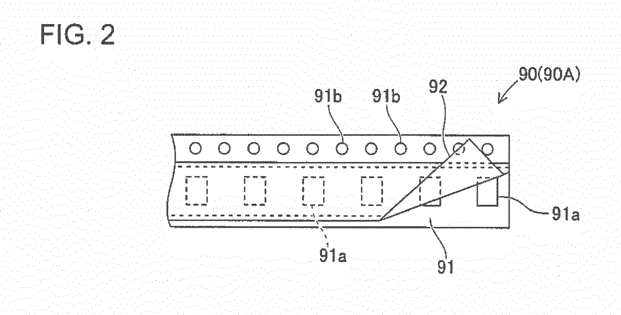

Referring to Fig. 2, the configuration of the carrier tape 90 will be described. The carrier tape 90 is wound around a reel held by a reel holding portion provided in a component supply device in the electronic component mounting machine. The carrier tape 90 accommodates a large number of electronic components in a row. As shown in FIG. 2, the carrier tape 90 has a base tape 91 and a cover tape 92.

The base tape 91 is formed of a flexible material such as a paper material or a resin. The base tape 91 has storage sections 91a formed at a central portion in a width direction (a vertical direction in Fig. 2). The storage sections 91a each have a recess having a bottom portion. The storage sections 91a are formed at regular intervals along the conveying direction of the base tape 91 (a longitudinal direction, that is, a right-to-left direction in Fig. 2) . The storage sections 91a each accommodate therein one electronic component.

The base tape 91 has feed holes 91b formed along an edge portion on one side thereof in the width direction. The feed holes 91b are formed at regular intervals in the conveying direction of the base tape 91. The feed holes 91b are each formed so as to penetrate the carrier tape 90 in a thickness direction thereof. In this embodiment, a space between the feed holes 91b is set smaller than a space between the storage sections 91a.

The cover tape 92 is formed of a thin film, which is a polymer film in this embodiment. Both end portions of the cover tape 92 in the width direction are bonded to an upper surface of the base tape 91. As a result, the cover tape 92 closes opening portions of the storage sections 91a. With the carrier tape configured in the way described above, the electronic components accommodated in the storage sections 91a of the base tape 91 are prevented from falling off.

### (Configuration of Feeder 1)

As shown in Fig. 1, the feeder 1 includes a feeder main body 10, a first drive device 20, a second drive device 30, a tape feeding unit 40, a tape guide 50, a cover member 60, a plurality of detection sensors 71 to 73, and a control unit 80. In the following description, a downstream side (a right-hand side in Fig. 1) in the conveying direction in which the carrier tape 90 is fed and moved will be referred to as a front side, while an upstream side (a left-hand side in Fig. 1) in the conveying direction will be referred to as a rear side.

The feeder main body 10 is formed into the shape of a flat box and is set in a slot of the component supply device which makes up the electronic component mounting machine. The feeder main body 10 has formed thereon a first inserting portion Dil into which the carrier tape 90 is inserted and a first conveying path R1 configured to support the carrier tape 90 inserted from the first inserting portion Di1. The first inserting portion Di1 is positioned at a rear portion of the feeder main body 10 and is positioned below the removing portion Dt.

The first conveying path R 1 is made up of a rail 11 of the feeder main body 10. The first conveying path R 1 is configured to have an inclined section Sn and a horizontal section Sh. The inclined section Sn extends from a height of the first inserting portion Dil to a height of the removing portion Dt in the first conveying path R1. The first inserting portion Di1 is located at a starting end of the inclined section Sn. The horizontal section Sh extends horizontally from a tail end of the inclined section Sn to the removing section Dt in the first conveying path R1.

The first drive device 20 has a pair of sprockets 21 provided below the rail 11 in the removing portion Dt. The second drive device 30 has a pair of sprockets 31 provided below the rail in the first inserting portion Di1. Each of the pairs of sprockets 21, 31 is disposed so as to partially protrude from a window formed in the rail 11 toward an upper surface side of the rail 11 to thereby be brought into engagement with the feeding holes 91b of the carrier tape 90.

The first drive device 20 and the second drive device 30 drive rotationally the corresponding pairs of sprockets 21, 31 independently or drive them rotationally synchronously by using corresponding stepping motors (not shown) . Due to this configuration, the first drive device 20 constitutes a drawing mechanism configured to draw the carrier tape 90 on the rail 11 into the removing portion Dt. Additionally, the second drive device 30 constitutes a feeding mechanism configured to feed and move an starting end of the carrier tape 90 from the first inserting portion Di1 to the first drive device 20, when the initiating end of the carrier tape 90 is inserted into the first inserting portion Di1.

The tape feeding unit 40 is disposed above the rail 11 in a position where the second drive device 30 is located in the conveying direction of the carrier tape 90. The tape feeding unit 40 presses the carrier tape 90 interposed between the rail 11 and itself against the rail 11. By doing so, the tape feeding unit 40 guides an engagement of the feeding holes 91b of the carrier tape 90 with the sprockets 31 of the second drive device 30. Additionally, the tape feeding unit 40 also holds another carrier tape 90 which is inserted in advance for a replenishment to the current carrier tape 90.

The tape guide 50 is disposed above the rail 11 in a position where the sprockets 21 of the first drive device 20 are located in the conveying direction of the carrier tape 90. The tape guide 50 restricts the carrier tape 90 which is in engagement with the sprockets 21 from moving upwards and laterally in the width direction to guide an engagement with the carrier tape 90 with the sprockets 21. A detailed configuration of the tape guide 50 will be described later.

The cover member 60 presses down an upper surface of the carrier tape 90 at a portion of the inclined section Sn of the first conveying path R1. The cover member 60 rotates about a shaft portion 61 to open the first conveying path R1. With the feeder 1 in use, the cover member 60 is locked on to the feeder main body 10 by a locking member 62. The cover member 60 has a plate spring 63 constituting a part of the second conveying path R2 and a pair of flange portions 64 configured to guide both transverse side edges of the carrier tape 90 which is inserted from the second inserting portion Di2. Details of the plate spring 63 and the pair of flange portions 64 will be described later.

A first detection sensor 71 is disposed in the horizontal section Sh of the first conveying path R1. A second detection sensor 72 is disposed at a middle portion Dn which is positioned between the removing portion Dt and the first inserting portion Di1. The first detection sensor 71 and the second detection sensor 72 detect whether or not the carrier tape 90 exists on the rail 11. A third detection sensor 73 is disposed on a circumference of the first inserting portion Di1. The third detection sensor 73 detects an operating state of the tape feeding unit 40.

The control device 80 mainly includes a CPU, various memories, and a control circuit. When the feeder 1 is set in the electronic component mounting machine, the control unit 80 is supplied with electric power from the electronic component mounting machine via a connector and is then allowed to communication with the electronic component mounting machine. The control unite 80 controls the operations of the first drive device 20 and the second drive device 30 based on a control command by the electronic component mounting machine or the results of detections made by the plurality of detection sensors 71 to 73.

Additionally, the control unit 80 recognizes which section on the conveying path a tail end of the carrier tape 90 is in based on the results of detections made by the plurality of detection sensors 71 to 73. For example, in the case where only the first detection sensor 71 is detecting the carrier tape 90, the control unit 80 recognizes that the tail end of the carrier tape 90 is located somewhere between the middle portion Dn and the removing portion Dt. In addition, the control unit 80 detects whether or not the current carrier tape 90 and another carrier tape 90 for replenishment exist at the first inserting portion Di1 based on the operation state of the tape feeding unit 40 detected by the third detection sensor 73.

### (Detailed Configuration of Tape Guide 50)

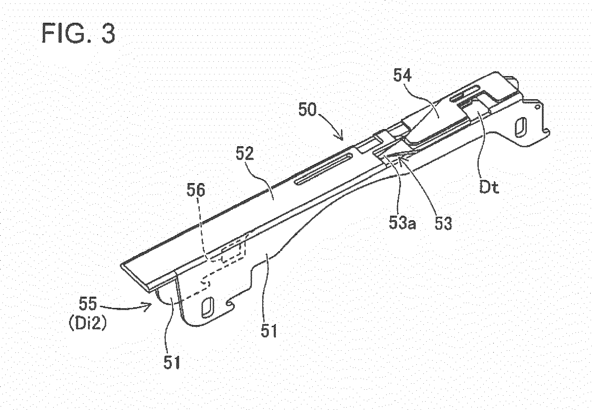

Referring to Fig. 3, a detailed configuration of the tape guide 50 will be described. The tape guide 50 is a unit configured not only to guide an engagement of the carrier tape 90 with the sprockets 21 as described above but also to separate the cover tape 92 of the carrier tape 90 so as to cause the accommodated electronic components to be exposed for removal. The tape guide 50 is such that a tape guide 50 is selected appropriately from a plurality of types of tape guides 50 for a carrier tape 90 to be used and is then mounted on the feeder main body 10.

As shown in Fig. 3, the tape guide 50 is formed into a U-shape whose cross-sectional shape taken along a plane which is at right angles to the conveying direction (a direction from a left bottom to a right top as seen in Fig. 3) is opened downwards. A pair of side walls 51 of the tape guide 50 which are situated opposed to each other are fixed to the feeder main body 10 by screws or the like. In the case where the carrier tape 90 is fed and moved along the first conveying path R1 or the second conveying path r2, the pair of side walls 51 restrict the carrier tape 90 from moving in the width direction to thereby guide a conveyance of the carrier tape 90.

A tape separating portion 53 configured to separate the cover tape 92 from the base tape 91 of the carrier tape 90 is formed on an upper wall 52 of the tape guide 50. The tape separating portion 53 has a cutter 53a fixed to the upper wall 52 of the tape guide 50. A cutting edge of the cutter 53 a is inserted between the base tape 91 and the cover tape 92 when the carrier tape 90 is fed and moved. As a result of the cutter 53 being so inserted, the cover tape 92 is separated from the base plate 91 on one edge side of both edge sides thereof in the width direction and is left bonded to the base tape 91 on the other edge side thereof.

A folding-back member 54 is provided between the tape separating portion 53 and the component removing portion Dt on the upper wall 52 of the tape guide 50. The folding-back member 54 has a plate shape and is configured to raise the one edge side of the cover tape 92 which is separated from the base tape 91 by the tape separating portion 53 to fold it back towards the other edge side. This opens the storage sections 91a of the base tape 91. Additionally, the removing portion Dt is formed in the upper wall 52 of the tape guide 50 so as to be opened for removal of the electronic components therefrom.

In this way, as the carrier tape 90 is fed and moved, the tape guide 50 separates the cover tape 92 and folds it back to expose the electronic components at the takeout portion Dt. A portion of the carrier tape 90 that has passed through the removing portion Dt is discharged to the outside of the feeder 1 in such a way as to hang down from a front side of the feeder 1.

The tape guide 50 has an opening portion 55 which opens at a rear end thereof. This opening portion 55 constitutes a second inserting portion Di2 which enables an insertion of a carrier tape 90 in a position located nearer to the removing portion Dt than the first inserting portion Di1 with the tape guide 50 mounted on the feeder main body 10. The tape guide 50 restricts a carrier tape 90 inserted from the second inserting portion Di2 from moving in the width direction by using one of the side walls 51 to guide a feeding and moving the carrier tape 90 along the second conveying path R2.

An identification mark 56 indicating the type of the tape guide 50 is affixed to an inner surface of one of the pair of side walls 51 of the tape guide 50. The identification mark 56 is read by a sensor (not shown) provided in the feeder main body 10. The control unit 80 recognizes the type of the tape guide 50 currently mounted based on the result of the detection made by the sensor. By doing so, the control device 80 can determine whether or not the currently loaded carrier tape 90 and the tape guide 50 match each other, for example.

### (Configurations of First Conveying Path R1 and Second Conveying Path R2)

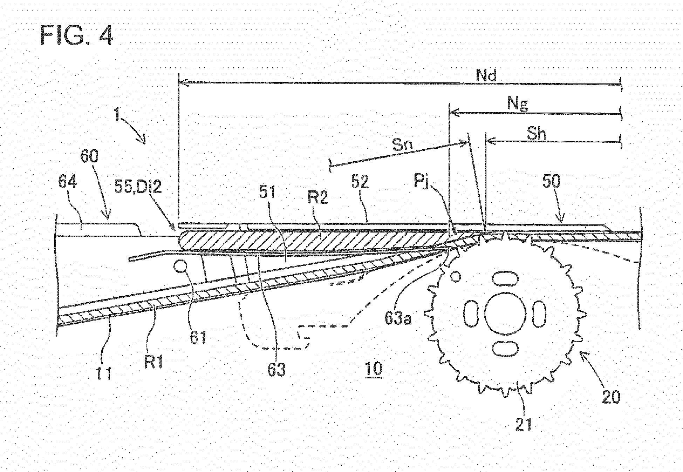

Referring to Figs. 4 to 8, the configurations of the first conveying path R1 and the second conveying path R2 will be described. The feeder 1 includes the first conveying path R1 made up of the rail 11 of the feeder main body 10 as described above. The first conveying path R1 is used mainly in supplying electronic components using the carrier tape 90 wound on a reel. Incidentally, in supplying electronic components using the feeder 1, there is a case where, for example, a carrier tape 90 which is shorter than the first conveying path R1 (hereinafter, also referred to as a "cut tape 90A") is used to cope with various production modes.

Then, in order to enable a use of the cut tape 90A, the feeder 1 of this embodiment includes the second inserting portion Di2 and the second conveying path R2 in addition to the first inserting portion Di1 and the first conveying path R1, as shown by hatched portions in Fig. 4. Additionally, the second insertion porting Di 2 is constituted by the opening portion 55 which opens at the rear end of the tape guide 50 as described above. The second inserting portion Di2 is located in a position lying nearer to the removing portion Dt than the first inserting portion Di1 to receive an insertion of the cut tape 90A.

The feeder 1 also includes a plate spring 63 provided on the cover member 60 as described above. The plate spring 63 is a support member configured to support the cut tape 90A inserted from the second inserting portion Di2 from the second inserting portion Di2 to a position where the first conveying path R 1 and the second conveying path R 2 merge together and forms a part of the second conveying path R2 . The plate spring 63 has elasticity and is formed into the shape of a plate which extends in a front-to-rear direction (a right-to-left direction in Fig. 4) of the feeder main body 10.

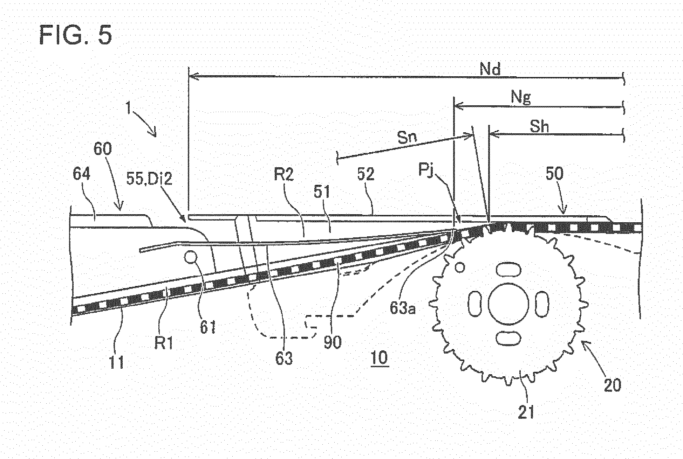

As shown in Fig. 4, in the case where the carrier tape 90 is not present on the first conveying path R1, one end portion 63a of the plate spring 63 is left in contact with the rail 11 constituting the first conveying path R1 by virtue of an elastic force of the plate spring 63. On the other hand, as shown in Fig. 5, in the case where the carrier tape 90 inserted from the first inserting portion Di1 is fed and moved along the first conveying path R1, the plate spring 63 biases the carrier tape 90 against the rail 11 constituting the first conveying path R1.

The second conveying path R2, which is configured as described above, is a conveying path configured to support the cut tape 90A inserted from the second inserting portion Di2 and merges into the first conveying path R1 within a range defined in the conveying direction on the first conveying path R1 where the tape guide 50 is positioned (hereinafter, also referred to as a "guide range Nd"), as shown in Fig. 4. In this embodiment, the second conveying path R2 merges into the first conveying path R1 within a range of the guide range Nd in which the carrier tape 90 (including the cut tape 90A) can be brought into contact with the sprockets 21 of the second drive device 20 for engagement therewith (hereinafter, also referred to as an "engaging range Ng").

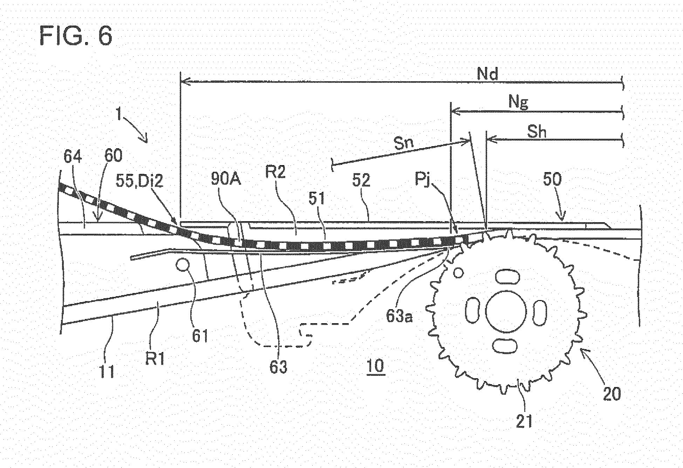

Namely, a merging position Pj between the first conveying path R1 and the second conveying path R2 is located within the engaging range Ng. Due to this configuration, as shown in Fig. 6, the cut tape 90A inserted from the second inserting portion Di 2 is brought into contact with the sprocket 21 when a leading end portion thereof reaches the merging position Pj. Then, the cut tape 90 A is brought into engagement with the sprockets 21 as the sprockets 21 rotate or the like, whereby one of the plurality of storage sections 91a reaches the component removing portion Dt, resulting in a loaded state where the cut tape 90A is loaded in the feeder 1.

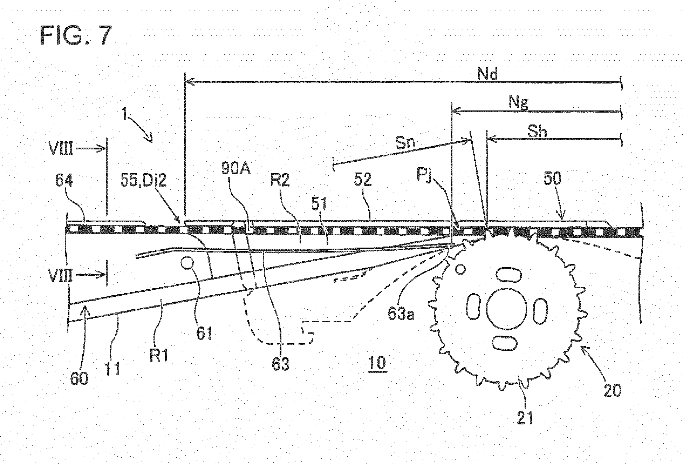

As this occurs, when the cut tape 90A inserted from the second inserting portion Di2 is fed and moved by the sprocket 21 as shown in Fig. 7, the cut tape 90A is no more left in contact with the rail 11 constituting the inclined section Sn. Namely, when the cut tape 90A inserted from the second insertion porting Di2 is loaded into the feeder 1, the cut tape 90A is held extending in a substantially horizontal direction. This prevents the cut tape 90A from being bent or the like, suppressing the generation of an operational load in feeding and moving the cut tape 90A.

In this way, in this embodiment, the tape guide 50 is used in both feeding and moving the carrier tape 90 using the first conveying path R1 and feeding and moving the cut tape 90A using the second conveying path R2. The plate spring 63 separates the first conveying path R1 from the second conveying path R2 and has a function of assisting in feeding and moving the carrier tape 90 along each of the first conveying path R1 and the second conveying path R2.

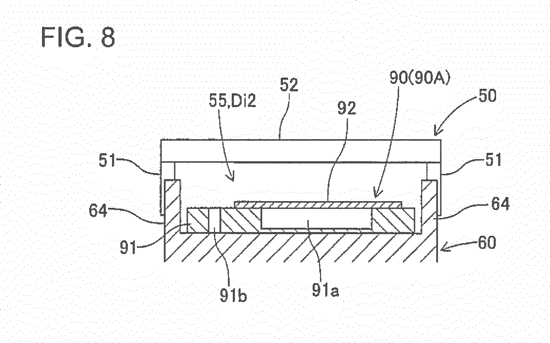

Here, the feeder 1 includes a pair of flange portions 64 provided on the cover member 60 as described above. As shown in Fig. 8, the pair of flange portions 64 are formed so as to project upwards from an upper portion of the cover member 60. The pair of flange portions 64 are disposed to face each other. A separation distance defined between the pair of flange portions 64 is set greater than a width of the cut tape 90A. By adopting the configuration described above, the pair of flange portions 64 guides both edges of the cut tape 90A inserted from the second insertion porting Di2 in the width direction and restricts the cut tape 90A from moving in the width direction. In this way, the pair of flange portions 64 prevents the cut tape 90A from falling off from an upper portion to a side of the cover member 60.

### (Advantageous Effects Resulting from the Configuration of the Embodiment)

The tape feeder 1 feeds and moves the carrier tape 90 carrying the electronic components in the conveying direction to supply the electronic components for removal. The carrier tape 90 includes the base tape 91 in which the storage sections 91a accommodating the electronic components are formed at regular intervals in the conveying direction and the cover tape 92 which closes the storage sections 91a. The tape feeder 1 includes the feeder main body 10 having formed therein the first inserting portion Di1 into which the carrier tape 90 is inserted and the first conveying path R1 configured to support the carrier tape 90 inserted from the first inserting portion Dil, the sprockets 21 configured to be brought into engagement with the carrier tape 90 to feed and move the carrier tape 90, the tape guide 50 configured to guide an engagement of the carrier tape 90 with the sprockets 21 above the sprockets 21 and having formed thereon the tape peeling section 53 configured to separate the cover tape 92 from the base tape 91 and the removing portion Dt which is opened at the upper surface thereof to enable a removal of the electronic components, the second inserting portion Di2 which is disposed in the position located nearer to the removing portion Dt than the first inserting portion Di1 and into which the carrier tape 90 is inserted, and the second conveying path R2 which is the conveying path configured to support the carrier tape 90 inserted from the second inserting portion Di2 and which merges into the first conveying path R1 within the range defined in the conveying direction on the first conveying path R1 where the tape guide 50 is located (the guide range Nd).

According to the configuration described above, the merging position Pj where the second conveying path R2 merges into the first conveying path R1 is within the guide range Nd where the tape guide 50 is located. This can shorten a distance from the merging position PJ to the sprocket 21. Additionally, the second inserting portion Di 2 is formed close to the engaging range Ng where the carrier tape 90 comes into contact with the sprocket 21 for engagement therewith, thereby making it possible to shorten the length of the second conveying path R2. This can not only facilitate a loading of the cut tape 90A but also shorten a minimum tape length that can be loaded into the feeder 1, thereby making it possible to use a shorter cut tape 90A.

Further, according to the configuration of this embodiment, the cut tape 90A is kept unbent or the like from the merging position Pj between the first conveying path R1 and the second conveying path R2 to the engaging range Ng with the sprockets 21. This suppresses the generation of an operational load in feeding and moving the carrier tape 90 or 90A. As a result, it becomes easy for the operator to recognize the state where a front end of the cut tape 90 A is in contact with the sprocket 21. This can improve the efficiency of a loading operation of the cut tape 90A.

The second conveying path R2 merges into the first conveying path R1 within the range (the engaging range Ng) where the carrier tape 90 comes into contact with the sprocket 21 for engagement therewith in the range (the guide range Nd) defined in the conveying direction on the first conveying path R1 where the tape guide 50 is located.

With this configuration, since the joining position Pj between the first conveying path R1 and the second conveying path R2 lies closer to the sprocket 21, the second insertion portion Di2 can be formed in a position located closer to the sprocket 21 in the engagement range Ng. This simplifies the second conveying path R2, which enables, for example, a visual confirmation of an engaging state between the cut tape 90A and the sprocket 21, thereby making it possible to improve the efficiency of the loading operation of the cut tape 90A.

The second inserting portion Di2 is formed in the tape guide 50. The tape guide 50 restricts the carrier tape 90 inserted from the second inserting portion Di2 from moving in the width direction and guides the carrier tape 90 along the second conveying path R2 in feeding and moving the carrier tape 90 .

With the configuration described above, the tape feeder 1 can cope with different cut tapes 90 A by replacing the tape guide 50 with corresponding tape guides 50. The tape guide 50 has the second inserting portion Di2 and guides the cut tape 90A in feeding and moving it. This can not only facilitate a loading of the cut tape 90A but also make a supplying operation of electronic components using the cut tape 90A more stable.

The second inserting portion Di2 is made up of the opening portion 55 that opens at a rear end of the tape guide 50. With this configuration, since the second inserting portion Di2 is disposed at the rear end of the tape guide 50, an insertion of the cut tape 90A can be facilitated.

In addition, the tape feeder 1 further includes the support member (the plate spring 63) configured to support the carrier tape 90 inserted from the second inserting portion Di2 from the second inserting portion Di2 to the position where the first conveying path R1 and the second conveying path R2 merge together and forming at least part of the second conveying path R2. The support member (the plate spring 63) has elasticity, and in the case where the carrier tape 90 inserted from the first inserting portion Di1 is fed and moved along the first conveying path R1, the support member (the plate spring 63) biases the carrier tape 90 against the rail 11 constituting the first conveying path R1.

With this configuration, the support member (the plate spring 63), which constitutes at least part of the second conveying path R2 biases the carrier tape 90 against the rail 11 of the first conveying path R1. This restricts the carrier tape 90 inserted from the first inserting portion Di1 from rising from the first conveying path R1, whereby the carrier tape 90 is preferably fed and moved.

The support member is the plate spring 63 which extends in the front-to-rear direction of the feeder main body 10. In the case where the carrier tape 90 is not present on the first conveying path R1, the one end portion 63a of the plate spring 63 is left in contact with the rail 11 constituting the first conveying path R1 by virtue of the elastic force of the plate spring 63.

With this configuration, in the case where the carrier tape 90 is not present on the first conveying path R1, a gap is not formed between the one end portion 63 a of the plate spring 63 and the rail 11 of the first conveying path R1. This enables the carrier tape 90 inserted from the second inserting portion Di 2 to be guided preferably as far as the engaging range Ng without being caught at the merging position Pj where the first conveying path R1 and the second conveying path R2 merge together. This can facilitate further a loading of the cut tape 90 A.

The first inserting portion Di 1 is located below the removing portion Dt. The first conveying path R1 has the inclined section Sn extending from the height of the first inserting portion Di1 to the height of the removing portion Dt and the horizontal section Sh extending horizontally from the tail end of the inclined section Sn to the removing portion Dt. When the carrier tape 90 inserted from the second inserting portion Di2 is fed and moved by the sprockets 21, the carrier tape 90 is separated from the rail 11 constituting the inclined section Sn.

With this configuration, when the carrier tape 90 inserted from the second inserting portion Di2 is loaded into the tape feeder 1, the carrier tape 90 is held extending substantially horizontally. This prevents the carrier tape 90 from being bent or the like. Therefore, it is possible to suppress the generation of an operational load in feeding and moving the carrier tape 90, thereby making it possible to make the supplying operation of electronic components more stable.

### <Modifications to the Embodiment>

### (As to Merging Position)

In the embodiment described above, the merging position Pj between the first conveying path R1 and the second conveying path R2 is positioned within the engaging range Ng. Although the embodiment is configured in the way described above, the joining position Pj may be set in a position located nearer to a rear end side of the tape guide 50 than the engaging range Ng, provided that the merging position PJ remains staying within the range defined in the conveying direction where the tape guide 50 is located (the guide range Nd).

As this occurs, depending on the position of the one end portion of the support member (the one end portion 63 a of the plate spring 63 in the embodiment), the cut tape 90 A may be supported by the rail 11 constituting the inclined section Sn somewhere from the merging position Pj to the engaging range Ng. In this configuration, the cut tape 90A can be prevented from being bent after it has been loaded by providing a gap of a certain magnitude between the upper wall 52 of the tape guide 50 and the cut tape 90A.

### (As to the Configuration of the Second Inserting Portion)

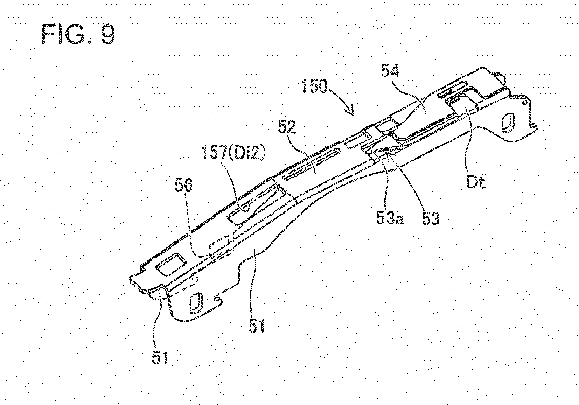

In the embodiment described above, the second inserting portion Di2 is made up of the opening portion 55 that opens in the tape guide 50. Although the embodiment is configured in the way described above, as shown in FIG. 9, the second inserting portion Di2 may be made up of a through hole 157 which is formed in an upper surface of a tape guide 150. With this configuration, since the second insertion portion Di2 is disposed in the upper surface of the tape guide 150, the second inserting portion Di2 can be located nearer to the engaging range Ng. This can shorten the length of the second conveying path R2, thereby making it possible to simplify further the loading of the cut tape 90A.

In addition to the formation of the second inserting portion Di2 in the tape guide 50, 150, the second inserting portion Di2 ma be formed in the feeder main body 10 or the like, provided that the second inserting portion Di2 is positioned nearer to the removing portion Dt than the first inserting portion Di1. For example, a conveying path which continues to the rear end of the tape guide 50 mounted on the feeder main body 10 is provided at an upper portion of the cover member 60, and the second inserting portion Di2 may be provided at a rear end of the conveying path so provided. With this configuration, too, the same advantageous effects as those of the embodiment can be obtained.

### (As to Support Member)

In the embodiment, the support member is described as being made up of the plate spring 63 which is the elastic member. Although the embodiment is configured in the way described above, the support member may be made up of a plate member having no elasticity and an elastic member that biases one end portion of the plate member towards the rail 11. Additionally, the elastic force of the support member and the position of the one end portion 63a in an initial state can be set as required according to a mode in which the support member is used.

In addition, in the embodiment, the plate spring 63, which is the support member, is provided on the cover member 60. Although the embodiment is configured in the way described above, the support member may be provided on the feeder main body 10 or the tape guide 50. For example, a support member extending in the front-to-rear direction of the feeder main body 10 is disposed at a lower portion of the opening portion 55 of the tape guide 50, and a second conveying path R2 is formed in an interior portion of the tape guide 50. With this configuration, employing the tape guide 50 configured as described above enables a use of the cut tape 90A in supplying electronic components without making any change to the other constituent parts of the feeder 1.

### (As to Control of Supplying Operation of Electronic Components)

In the embodiment, in the case where the carrier tape 90 inserted into the second inserting portion Di2 is used in supplying electronic components, the control unit 80 is designed not to reflect the results of detections made by the second detection sensor 72 disposed at the middle portion Dn and the third detection sensor 73 disposed on the circumference of the first inserting portion Di1 to its control.

This is a measure designed to be taken to prevent the feeder 1, which is of an autoloading type, from executing a process of automatically loading another carrier tape 90 for replenishment due to the feeder 1 erroneously recognizing that the remaining amount of the current carrier tape 90 is equal to or less than a prescribed amount. Specifically, in the case where the second detection sensor 72 does not detect the carrier tape 90, the control unit 80 recognizes a tail end of the current carrier tape 90 comes close to the removing portion Dt even though the cut tape 90A is used in reality.

As this occurs, when various conditions including a detection of a carrier tape 90 for replenishment by the third detection sensor 73 are satisfied, the process of loading the carrier tape 90 for replenishment is executed. As a result, the cut tape 90A loaded without traveling by way of the middle portion Dn is discharged, and the supplying operation of electronic component using the cut tape 90A cannot be properly controlled.

Then, the control unit 80 switches the operation modes through, for example, an operator's switching operation and reflects or does not reflect the results of detections made by the second and third detection sensors 72, 73 to its control in controlling the supplying operation of electronic components. In the case where the tape guide 50 is an exclusive unit designed exclusively to feed and move the cut tape 90 A using the second conveying path R2, the control device 80 may be made to recognize that the unit is the exclusive unit by reading, for example, the identification mark 56 to automatically switch the operation modes.

### Description of Reference Numerals and Characters

1: feeder (tape feeder); 10: feeder main body; 11 : rail; 20: first drive device; 21: sprocket; 30: second drive device; 31: sprocket; 40: tape feeding unit; 50, 150: tape guide ; 51: side wall; 52: upper wall; 53: tape separating portion; 53a : cutter; 54: folding-back member; 55: opening portion; 56: identification mark; 157: through hole; 60: cover member; 61: shaft portion; 62: locking member; 63: plate spring (support member) ; 63a: one end portion; 64: flange portion; 71 to 73: detection sensor; 80: control unit; 90: carrier tape; 90A: cut tape (carrier tape) ; 91: base tape; 91a: storage section; 91b: feeding hole; 92: cover tape; R1: first conveying path; Sn: inclined section; Sh: horizontal section; R2: second conveying path; Pj: merging position; Dt: removing portion; Dn: middle portion; Dil: first inserting portion; Di2: second inserting portion; Nd: guide range; Ng: engaging range.

## Claims

1. A tape feeder (1) for feeding and moving a carrier tape (90) carrying electronic components in a conveying direction to supply the electronic components for removal, the carrier tape (90, 90A) having a base tape (91) on which storage sections (91a) for accommodating an electronic component are formed at regular intervals in the conveying direction and a cover tape (92) for closing the storage sections (91a), the tape feeder (1) comprising:
a feeder main body (10) having formed therein a first inserting portion (Di1) into which a first carrier tape (90) is inserted and a first conveying path (R1) configured to support the first carrier tape (90) inserted from the first inserting portion (Di1);
a sprocket (21) configured to be brought into engagement with either the first carrier tape (90) or a second carrier tape (90A) to feed and move the first or the second carrier tape (90, 90A);
a tape guide (50, 150) configured to guide the engagement of the first or the second carrier tape (90, 90A) with the sprocket (21) above the sprocket (21) and having formed thereon a tape separating portion (53) configured to separate the cover tape (92) from the base tape (91) and a removing portion (Dt) which is opened at an upper surface to enable a removal of the electronic components;
a second inserting portion (Di2) which is disposed in a position located nearer to the removing portion (Dt) than the first inserting portion (Di1) and into which the second carrier tape (90A) is inserted; and
a second conveying path (R2) which is a conveying path configured to support the second carrier tape (90A) inserted from the second inserting portion (Di2) and which merges into the first conveying path (R1) within a range (Nd) defined in the conveying direction on the first conveying path (R1) where the tape guide (50, 150) is located,
wherein the second inserting portion (Di2) is formed in the tape guide (50, 150), and
wherein the tape guide (50, 150) restricts the second carrier tape (90A) inserted from the second inserting portion (Di2) from moving in the width direction to guide a feeding and moving of the second carrier tape (90A) along the second conveying path (R2).

2. The tape feeder according to claim 1,
wherein the second conveying path (R2) merges into the first conveying path (R1) within a range where the first or second carrier tape (90A) is brought into contact with the sprocket (21) for engagement therewith in the range (Nd) defined in the conveying direction on the first conveying path (R1) where the tape guide (50, 150) is located.

3. The tape feeder according to claim 1,
wherein the second inserting portion (Di2) comprises an opening portion (55) which opens at a rear end of the tape guide (50, 150).

4. The tape feeder according to claim 1,
wherein the second inserting portion (Di2) comprises a through hole (157) formed in an upper surface of the tape guide (50, 150).

5. The tape feeder according to any of claims 1 to 4, comprising further:
a support member (63) configured to support the second carrier tape (90A) inserted from the second inserting portion (Di2) to a position where the first conveying path (R1) and the second conveying path (R2) merge together and making up at least part of the second conveying path (R2),
wherein the support member (63) has elasticity and biases the first carrier tape (90A) against a rail (11) making up the first conveying path (R1) in a case where the first carrier tape (90) inserted from the first inserting portion (Di1) is fed and moved along the first conveying path (R1).

6. The tape feeder according to claim 5,
wherein the support member (63) is a plate spring extending in a front-to-rear direction of the feeder main body (10), and
wherein one end portion (63a) of the plate spring (63) is brought into contact with the rail (11) making up the first conveying path (R1) by virtue of an elastic force of the plate spring (63) in a case where the first carrier tape (90) is not present on the first conveying path (R1).

7. The tape feeder according to claim 5 or 6,
wherein the first inserting portion (Di1) is positioned below the removing portion (Dt),
wherein the first conveying path (R1) has an inclined section (Sn) extending from a height of the first inserting portion (Di1) to a height of the removing portion (Dt) and a horizontal section (Sh) extending horizontally from a tail end of the inclined section (Sn) to the removing portion (Dt), and
wherein the second carrier tape (90A) inserted from the second inserting portion (Di2) is separated from the rail (11) making up the inclined section (Sn) in a case where the second carrier tape (90) is fed and moved by the sprocket (21).

## Patentansprüche

1. Band-Zuführvorrichtung (1) zum Zuführen und Bewegen eines Trägerbandes (90), das elektronische Bauteile in einer Förderrichtung transportiert, um die elektronischen Bauteile zur Entnahme bereitzustellen,
das Trägerband (90, 90A) ein Basisband (91), an dem Speicherabschnitte (91a) zum Aufnehmen eines elektronischen Bauteils in der Transportrichtung in regelmäßigen Abständen ausgebildet sind, sowie ein Abdeckband (92) zum Verschließen der Speicherabschnitte (91a) aufweist, wobei die Band-Zuführvorrichtung (1) umfasst:
einen Hauptkörper (10) der Zuführvorrichtung, in dem ein erster Einführabschnitt (Di1), in den ein erstes Trägerband (90) eingeführt wird, und ein erster Förderweg (R1) ausgebildet sind, der so ausgeführt ist, dass er das über den ersten Einführabschnitt (Di1) eingeführte erste Trägerband (90) trägt;
ein Kettenrad (21), das so ausgeführt ist, dass es entweder mit dem ersten Trägerband (90) oder einem zweiten Trägerband (90A) in Eingriff gebracht wird, um das erste oder das zweite Trägerband (90, 90A) zuzuführen und zu bewegen;
eine Bandführung (50, 150), die so ausgeführt ist, dass sie den Eingriff des ersten oder des zweiten Trägerbandes (90, 90A) mit dem Kettenrad (21) oberhalb des Kettenrades (21) führt, und an der ein Band-Trennabschnitt (53), der so ausgeführt ist, dass er das Abdeckband (92) von dem Basisband (91) trennt, sowie ein Entnahmeabschnitt (Dt) ausgebildet sind, der an einer Oberseite offen ist, um eine Entnahme der elektronischen Bauteile zu ermöglichen;
einen zweiten Einführabschnitt (Di2), der an einer Position angeordnet ist, die näher an dem Entnahmeabschnitt (Dt) liegt als der erste Einführabschnitt (Di1), und in den das zweite Trägerband (90A) eingeführt wird; und
einen zweiten Förderweg (R2), der ein Förderweg ist, der so ausgeführt ist, dass er das über den zweiten Einführabschnitt (Di2) eingeführte zweite Trägerband (90A) trägt, und der in den ersten Förderweg (R1) innerhalb eines Bereiches (Nd) einmündet, der in der Förderrichtung auf dem ersten Förderweg (R1) dort ausgebildet ist, wo sich die Bandführung (50, 150) befindet,
wobei der zweite Einführabschnitt (Di2) in der Bandführung (50, 150) ausgebildet ist, und
die Bandführung (50, 150) das über den zweiten Einführabschnitt (Di2) eingeführte zweite Trägerband (90A), daran hindert, sich in der Breitenrichtung zu bewegen, um ein Zuführen und Bewegen des zweiten Trägerbandes (90A) an dem zweiten Förderweges (R2) entlang zu führen.

2. Band-Zuführvorrichtung nach Anspruch 1,
wobei der zweite Förderweg (R2) in den ersten Förderweg (R1) innerhalb eines Bereichs einmündet, in dem das erste oder das zweite Trägerband (90A) mit dem Kettenrad (21) in Kontakt gebracht wird, um Eingriff damit in dem Bereich (Nb) herzustellen, der in der Förderrichtung auf dem ersten Förderweg (R1) dort ausgebildet ist, wo sich die Bandführung (50, 150) befindet.

3. Band-Zuführvorrichtung nach Anspruch 1,
wobei der zweite Einführabschnitt (Di2) einen Öffnungsabschnitt (55) umfasst, der sich an einem hinteren Ende der Bandführung (50, 150) öffnet.

4. Band-Zuführvorrichtung nach Anspruch 1,
wobei der zweite Einführabschnitt (Di2) ein Durchgangsloch (157) umfasst, das in einer Oberseite der Bandführung (50, 150) ausgebildet ist.

5. Band-Zuführvorrichtung nach einem der Ansprüche 1 bis 4, die des Weiteren umfasst:
ein Trageelement (63), das so ausgeführt ist, dass es das zweite Trägerband (90A) trägt, das über den zweiten Einführabschnitt (Di2) an eine Position eingeführt ist, an der der erste Förderweg (R1) und der zweite Förderweg (R2) zusammentreffen, und wenigstens einen Teil des zweiten Förderwegs (R2) bildet,
wobei das Trageelement (63) Elastizität aufweist und das erste Trägerband (90A) an eine Schiene (11) spannt, die den ersten Förderweg (R1) bildet, wenn das über den ersten Einführabschnitt (Di1) eingeführte erste Trägerband (90) an dem ersten Förderwegs (R1) entlang zugeführt und bewegt wird.

6. Band-Zuführvorrichtung nach Anspruch 5,
wobei das Trageelement (63) eine Blattfeder ist, die sich in einer Längsrichtung des Hauptkörpers (10) der Zuführvorrichtung erstreckt, und
ein Endabschnitt (63a) der Blattfeder (63) durch eine elastische Kraft der Blattfeder (63) in Kontakt mit der den ersten Förderweg (R1) bildenden Schiene (11) gebracht wird, wenn sich das erste Trägerband (90) nicht auf dem ersten Förderweg (R1) befindet.

7. Band-Zuführvorrichtung nach Anspruch 5 oder 6,
wobei der erste Einführabschnitt (Di1) unterhalb des Entnahmeabschnitts (Dt) angeordnet ist,
der erste Förderweg (R1) einen geneigten Teilabschnitt (Sn), der sich von einer Höhe des ersten Einführabschnitts (Di1) zu einer Höhe des Entnahmeabschnitts (Dt) erstreckt, sowie einen horizontalen Abschnitt (Sh) aufweist, der sich horizontal von einem hinteren Ende des geneigten Teilabschnitts (Sn) zu dem Entnahmeabschnitt (Dt) erstreckt, und
das über den zweiten Einführabschnitt (Di2) eingeführte zweite Trägerband (90A) von der Schiene (11) getrennt wird, die den geneigten Teilabschnitt (Sn) bildet, wenn das zweite Trägerband (90) durch das Kettenrad (21) zugeführt und bewegt wird.

## Revendications

1. Dispositif d'alimentation de bande (1) pour alimenter et déplacer une bande de support (90) supportant des composants électroniques dans une direction de transport pour fournir les composants électroniques à retirer,
la bande de support (90, 90A) ayant une bande de base (91) sur laquelle des sections de stockage (91a) pour recevoir un composant électronique sont formées à des intervalles réguliers dans la direction de transport et une bande de recouvrement (92) pour fermer les sections de stockage (91a), le dispositif d'alimentation de bande (1) comprenant :
un corps principal d'alimentation (10) dans lequel sont formés une première partie d'insertion (Di1) dans laquelle est insérée une première bande de support (90) et un premier chemin de transport (R1) configuré pour supporter la première bande de support (90) insérée depuis la première partie d'insertion (Di1) ;
un pignon (21) configuré pour être mis en prise avec la première bande de support (90) ou une seconde bande de support (90A) pour alimenter et déplacer la première ou la seconde bande de support (90, 90A) ;
un guide de bande (50, 150) configuré pour guider la mise en prise de la première ou de la seconde bande de support (90, 90A) avec le pignon (21) au-dessus du pignon (21) et sur lequel sont formées une partie de séparation de bande (53) configurée pour séparer la bande de recouvrement (92) depuis la bande de base (91) et une partie de retrait (Dt) qui est ouverte au niveau d'une surface supérieure pour permettre un retrait des composants électroniques ;
une seconde partie d'insertion (Di2) qui est disposée dans une position située plus près de la partie de retrait (Dt) que la première partie d'insertion (Di1) et dans laquelle la seconde bande de support (90A) est insérée ; et
un second chemin de transport (R2) qui est un chemin de transport configuré pour supporter la seconde bande de support (90A) insérée depuis la seconde partie d'insertion (Di2) et qui se combine au premier chemin de transport (R1) dans une plage (Nd) définie dans la direction de transport sur le premier chemin de transport (R1) où est situé le guide de bande (50, 150),
dans lequel la seconde partie d'insertion (Di2) est formée dans le guide de bande (50, 150), et
dans lequel le guide de bande (50, 150) empêche la seconde bande de support (90A) insérée depuis la seconde partie d'insertion (Di2) de se déplacer dans la direction de largeur pour guider une alimentation et un déplacement de la seconde bande de support (90A) le long du second chemin de transport (R2).

2. Dispositif d'alimentation de bande selon la revendication 1,
dans lequel le second chemin de transport (R2) se combine au premier chemin de transport (R1) dans une plage où la première ou la seconde bande de support (90A) est mise en contact avec le pignon (21) pour venir en prise avec celui-ci dans la plage (Nd) définie dans la direction de transport sur le premier chemin de transport (R1) où est situé le guide de bande (50, 150).

3. Dispositif d'alimentation de bande selon la revendication 1,
dans lequel la seconde partie d'insertion (Di2) comprend une partie d'ouverture (55) qui s'ouvre à une extrémité arrière du guide de bande (50, 150).

4. Dispositif d'alimentation de bande selon la revendication 1,
dans lequel la seconde partie d'insertion (Di2) comprend un trou traversant (157) formé dans une surface supérieure du guide de bande (50, 150).

5. Dispositif d'alimentation de bande selon l'une quelconque des revendications 1 à 4, comprenant en outre :
un élément de support (63) configuré pour supporter la seconde bande de support (90A) insérée depuis la seconde partie d'insertion (Di2) jusqu'à une position où le premier chemin de transport (R1) et le second chemin de transport (R2) se combinent ensemble et constituant au moins une partie du second chemin de transport (R2),
dans lequel l'élément de support (63) possède une élasticité et sollicite la première bande de support (90A) contre un rail (11) constituant le premier chemin de transport (R1) dans un cas où la première bande de support (90) insérée depuis la première partie d'insertion (Di1) est alimentée et déplacée le long du premier chemin de transport (R1).

6. Dispositif d'alimentation de bande selon la revendication 5,
dans lequel l'élément de support (63) est un ressort à lames s'étendant dans une direction d'avant en arrière du corps principal d'alimentation (10), et
dans lequel une partie d'extrémité (63a) du ressort à lames (63) est mise en contact avec le rail (11) constituant le premier chemin de transport (R1) du fait d'une force élastique du ressort à lames (63) dans un cas où la première bande de support (90) n'est pas présente sur le premier chemin de transport (R1).

7. Dispositif d'alimentation de bande selon la revendication 5 ou 6,
dans lequel la première partie d'insertion (Di1) est positionnée en dessous de la partie de retrait (Dt),
dans lequel le premier chemin de transport (R1) a une section inclinée (Sn) s'étendant d'une hauteur de la première partie d'insertion (Di1) jusqu'à une hauteur de la partie de retrait (Dt) et une section horizontale (Sh) s'étendant horizontalement à partir d'une extrémité arrière de la section inclinée (Sn) jusqu'à la partie de retrait (Dt), et dans lequel la seconde bande de support (90A) insérée depuis la seconde partie d'insertion (Di2) est séparée du rail (11) constituant la section inclinée (Sn) dans un cas où la seconde bande de support (90) est alimentée et déplacée par le pignon (21).
